# EUROPÄISCHE PATENTSCHRIFT

(11) **EP 1 810 947 B1**
(45) Veröffentlichungstag und Bekanntmachung des Hinweises auf die Patenterteilung: **22.06.2016**
(21) Anmeldenummer: 07107755.6
(22) Anmeldetag: 20.04.2001
(51) Int. Cl.: G01L 9/00, B81C 1/00, H01L 21/3063

(54) **Verfahren zur Herstellung eines Halbleiter-Bauelements sowie ein nach dem Verfahren hergestelltes Halbleiterbauelement**
Semiconductor device and its process of fabrication
Dispositif semi-conducteur et son procédé de fabrication

(30) Priorität: 05.07.2000 DE 10032579
(43) Veröffentlichungstag der Anmeldung: 25.07.2007
(62) Teilanmeldung aus: 01940181.9
(73) Patentinhaber: ROBERT BOSCH GMBH, 70442 Stuttgart (DE)
(72) Erfinder: Benzel, Hubert, 72124, Pliezhausen (DE); Weber, Heribert, 72622, Nuertingen (DE); Artmann, Hans, 71034, Boeblingen-Dagersheim (DE); Schaefer, Frank, 72070, Tuebingen (DE)

(56) Entgegenhaltungen:
- EP-A1- 0 895 276
- WO-A1-99/45583
- US-A- 5 464 509
- LANG W ET AL: "POROUS SILICON TECHNOLOGY FOR THERMAL SENSORS", SENSORS AND MATERIALS, SCIENTIFIC PUBLISHING DIVISION OF MYU, TOKYO, JP, Bd. 8, Nr. 6, 1. Januar 1996 (1996-01-01), Seiten 327-344, XP000609408, ISSN: 0914-4935

## Beschreibung

### Stand der Technik

Die Erfindung geht aus von einem Verfahren zur Herstellung eines Halbleiterbauelements, wie insbesondere ein mehrschichtiges Halbleiterbauelement, und von einem verfahrensgemäß hergestellten Halbleiterbauelement nach der Gattung des betreffenden unabhängigen Patentanspruchs.

Halbleiterbauelemente, wie insbesondere mikromechanische Drucksensoren, werden in der Regel in sogenannter Bulk- oder Oberflächenmikromechanik hergestellt. Die Herstellung von bulkmikromechanischen Bauelementen ist relativ aufwendig und damit teuer. Bei bekannten oberflächenmikromechanischen Bauelementen ist die Herstellung einer Kaverne aufwendig. Eine übliche Prozeßfolge zur Herstellung einer Kaverne in Oberflächenmikromechanik besteht insbesondere aus dem Abscheiden einer Opferschicht, dem Abscheiden einer Membranschicht, die meist aus Polysilizium besteht, dem Erzeugen von Öffnungen in der Membranschicht bzw. dem Öffnen eines lateralen Ätzkanals, dem Herausätzen der Opferschicht und dem Verschließen der Öffnungen, wobei beim Verschließen der Kaverneninnendruck definiert wird. In solcher Weise hergestellte oberflächenmikromechanische Drucksensoren haben zudem den Nachteil, daß ein auf sie einwirkender Druck meist nur über ein kapazitives Verfahren ausgewertet werden kann. Eine piezoresistive Auswertung des auf sie einwirkenden Drucks ist schwierig, da es durch bekannte oberflächenmikro-mechanische Verfahren lediglich möglich ist, piezoresistive Widerstände aus polykristallinem Silizium herzustellen. Diese haben gegenüber piezoresistiven Widerständen aus einkristallinem Silizium den Nachteil einer geringen Langzeitstabilität, wobei sie zusätzlich auch noch einen geringen piezoelektrischen Effekt aufweisen.

W. Lang et al, in Sensors and Materials, Bd. 8, Nr 6, Seiten 327-344 offenbart die Verwendung von porösen Silizium in der Herstellung von Sensoren.

Die Patentanmeldung EP 0 895 276 A1 offenbart ein Silizium-Drucksensor, wobei eine Kavität durch Ätzen von porösen Silizium hergestellt wird.

### Vorteile der Erfindung

Das erfindungsgemäße Verfahren mit den kennzeichnenden Merkmalen des betreffenden unabhängigen Patentanspruchs hat demgegenüber insbesondere den Vorteil, daß ein ein kapazitiver Drucksensor, der Widerstände aufweist, deren Widerstandswert sich aufgrund der Durchbiegung einer Membran des Drucksensors bei Druckbeaufschlagung ändert, einfach und kostengünstig in Oberflächenmikromechanik hergestellt werden kann. Durch die in den abhängigen Patentansprüchen aufgeführten Maßnahmen sind vorteilhafte Weiterbildungen und Verbesserungen des Verfahrens und des Halbleiterbauelements nach den betreffenden unabhängigen Patentansprüchen ermöglicht.
Ein wesentlicher Aspekt der Erfindung besteht darin, eine Kaverne bzw. einen Hohlraum in einem Halbleitersubstrat, wie insbesondere in einem Siliziumsubstrat, mit einem Ätzmedium zu schaffen. Hierzu wird die Deckschicht des Substrats im Bereich der nachfolgend erzeugten Kaverne derart geätzt, daß in dieser Öffnungen bzw. Ätzöffnungen, wie insbesondere Poren bzw. Hohlräume, entstehen. Über die Ätzöffnungen bzw. nach außen offenen Poren gelangt das Ätzmedium oder ein oder mehrere weitere Ätzmedien an tiefere Bereiche des Substrats. Der in diesem Bereich von dem Ätzmedium bzw. von den weiteren Ätzmedien zersetzte Teil des Halbleitersubstrats wird bevorzugt über die Öffnungen bzw. Poren der Deckschicht und/oder über eine externe Zugangsöffnung zu diesem Bereich entfernt. Die Deckschicht weist vorzugsweise eine Dicke von ca. 2 bis 10 µm, wie insbesondere 3 bis 5 µm, auf. Im Falle einer Zugangsöffnung wird bevorzugt, anstelle einer porösen Deckschicht von ca. 2 bis 10 µm, eine poröse Deckschicht gebildet, die bevorzugt eine Dicke von ca. 40 bis 80 µm, wie insbesondere 50 bis 60 µm, aufweist. Die größere Dicke hat den Zweck, daß die Deckschicht als Ätz-Pufferschicht beim Ätzen der Zugangsöffnung dienen kann und so einen sicheren Ätzstop vor einer auf der Deckschicht abgeschiedenen Epitaxieschicht ermöglicht. Im Falle eines Drucksensors bildet die auf der Deckschicht abgeschiedene Epitaxieschicht die eigentliche Sensormembran.
Bei einer bevorzugten Ausführungsform der Erfindung werden beim Ätzvorgang Maßnahmen ergriffen, die dafür sorgen, daß die Ausdehnungsgeschwindigkeit der Poren in der Deckschicht geringer, vorzugsweise deutlich geringer, als die Ausdehnungsgeschwindigkeit der Poren bzw. Hohlräume in dem Bereich des Substrats ist, der den späteren Hohlraum bzw. die Kaverne bildet.
Dies wird nach einer vorteilhaften Ausführungsform der Erfindung erreicht, indem die Ätzparameter und/oder das oder die Ätzmedien beim Ätzen der Poren in der Deckschicht und die Ätzparameter und/oder das oder die Ätzmedien beim Ätzen der Poren bzw. Hohlräume in dem Bereich der späteren Kaverne unterschiedlich gewählt sind.

Hieran ist insbesondere vorteilhaft, daß die Porosität der Deckschicht zum Abtransport des zur Herstellung der Kaverne zu zersetzenden Siliziums in prozeßtechnisch gut kontrollierbarer Weise bevorzugt lediglich angemessen groß einstellbar ist. Andererseits kann die Kaverne jedoch schnell und damit kostengünstig hergestellt werden.
Nach einer bevorzugten Ausführungsform der Erfindung ist vorgesehen, die Ätzparameter derart einzustellen und/oder das oder die Ätzmedien beim Ätzen der Kaverne derart zu wählen, daß die Ausdehnungsgeschwindigkeit der Poren bzw. Hohlräume derart hoch ist, daß die Poren bzw. Hohlräume sehr rasch miteinander "überlappen". Hierdurch entsteht zunächst ein einziger weitgehend flächenhafter Ausgangshohlraum im Substrat, der sich mit fortschreitender Zeit in die Tiefe ausdehnt und die Kaverne bildet.

Bei einer bevorzugten, zur unmittelbar vorstehenden Ausführungsform alternativen Ausführungsform der Erfindung ist vorgesehen, die Ätzparameter und/oder das oder die Ätzmedien beim Ätzen der Kaverne derart zu wählen, daß die Porosität des Bereichs des Substrats, der die spätere Kaverne bildet, größer als die Porosität der Deckschicht ist. Bevorzugt weist die Vorstufe der späteren Kaverne eine Porosität von mehr als 80 % auf. Vorzugsweise wird die Kaverne nachfolgend aus dem porösen Bereich des Substrats unter Ausführung von einem oder mehreren Temperschritten, vorzugsweise über ca. 900 °C, gebildet.

Bei einer Temperung, bevorzugt unter einer Wasserstoff- , Stickstoff- oder Edelgasatmosphäre, wie bei Temperaturen über ca. 900 °C, ordnen sich die Poren im Bereich des Siliziums, der die spätere Kaverne bildet, bei einer Porosität von ca. mehr als 80 % um, wodurch unter der gering porösen Deckschicht bzw. Startschicht für eine nachfolgend abzuscheidende Epitaxieschicht eine einzelne große Pore, also ein Hohlraum bzw. eine Kaverne, entsteht. Die Poren auf der Oberseite der gering porösen Schicht bzw. Startschicht werden bei diesem Hochtemperaturschritt weitgehend verschlossen, so daß auf der Startschicht eine weitgehend monokristalline Siliziumschicht, die die eigentliche Sensormembran bildet, abgeschieden werden kann.

Gemäß einer bevorzugten Ausführungsform der Erfindung handelt es sich bei dem Ätzmedium und/oder den Ätzmedien zur Erzeugung der Öffnungen und/oder Poren in der Deckschicht und/oder zur Erzeugung der Kaverne um Flußsäure (HF) oder um eine flüssige Mischung oder eine chemische Verbindung, die Flußsäure enthält.

Bei einer bevorzugten Ausführungsform der Erfindung wird dem Ätzmedium bzw. den Ätzmedien ein leicht flüchtiger Bestandteil, vorzugsweise ein Alkohol, wie z. B. Äthanol, und/oder gereinigtes Wasser zur Verdünnung des Ätzmediums bzw. der Ätzmedien beigegeben.

Äthanol reduziert die Oberflächenspannung eines mit ihm versehenen Ätzmediums, wodurch eine bessere Benetzung der Siliziumoberfläche und ein besseres Eindringen des Ätzmediums in geätzte Poren bzw. Öffnungen bzw. Hohlräume ermöglicht wird. Ferner sind die während des Ätzvorgangs entstehenden Blasen kleiner als ohne die Zugabe von Äthanol zum Ätzmedium und die Blasen können so besser durch die Poren der Deckschicht entweichen. Daher läßt sich die Porengröße und/oder die Porosität der Deckschicht in vorteilhafter Weise kleiner halten als ohne die Zugabe des Alkohols.

Bei einer weiteren bevorzugten Ausführungsform der Erfindung ist vorgesehen, die Öffnungen und/oder Poren in der Deckschicht und/oder im Bereich der späteren Kaverne mit einem elektrochemischen Verfahren, vorzugsweise unter Verwendung des vorgenannten Ätzmediums bzw. der vorgenannten Ätzmedien, zu erzeugen.
Ferner ist bei einer bevorzugten Ausführungsform der Erfindung unter Verwendung eines elektrochemischen Ätzverfahrens, vorzugsweise ein Ätzverfahren unter Verwendung von Flußsäure (HF), vorgesehen, die Ausdehnungsgeschwindigkeit der beim Ätzvorgang entstehenden Poren oder Hohlräume durch das Anlegen einer elektrischen Spannung und eines hierdurch hervorgerufenen elektrischen Stroms durch das Ätzmedium bzw. die Ätzmedien zu beeinflussen. Die Ausdehnungsgeschwindigkeit der Poren bzw. Hohlräume ist insbesondere abhängig von der Dotierung des zu ätzenden Siliziumsubstrats, der Stromdichte, ggf. der HF-Konzentration im Ätzmedium und der Temperatur. Es versteht sich, daß dies lediglich Beispiele relevanter Verfahrensparameter eines erfindungsgemäßen Ätzverfahrens sind.

Nach einer bevorzugten Ausführungsform der Erfindung wird das Ätzmedium, die HF-Konzentration im Ätzmedium und/oder die Dotierung des zu ätzenden Bereichs und/oder die Temperatur und ggf. weitere Prozeßparameter des Ätzverfahrens derart gewählt, daß sich der Ätzvorgang bzw. die Poren- bzw. Hohlraumbildung in geeigneter Weise einstellen und/oder mit dem Ausschalten der elektrischen Spannung abstellen läßt, vorzugsweise weitgehend abrupt.

Bei einem erfindungsgemäß bevorzugten elektrochemischen Ätzverfahren mit einem einzigen Ätzmedium und/oder mit zwei oder mehreren Ätzmedien wird in einem ersten Zeitraum, während dem sich das Ätzmedium im Bereich der Deckschicht befindet, eine erste, nicht notwendigerweise zeitlich konstante Stromdichte im Ätzmedium eingestellt. Während eines zweiten Zeitraums, zu dem sich das betreffende Ätzmedium im Bereich der zu schaffenden Kaverne befindet, wird bevorzugt eine zweite, nicht notwendigerweise zeitlich konstante Stromdichte eingestellt, die höher oder deutlich höher als die oder eine während des ersten Zeitraums eingestellte Stromdichte ist.
Hierdurch wird die Kaverne oder ein Vorstadium der Kaverne durch Poren bzw. Hohlräume gebildet, deren Ausdehnungsgeschwindigkeit während des Ätzvorgangs der Kaverne höher oder deutlich höher als die Ausdehnungsgeschwindigkeit der Poren zur Herstellung der porösen Deckschicht ist.

Bei einer weiteren bevorzugten Ausführungsform der Erfindung ist vorgesehen, den porös zu ätzenden Bereich der Deckfläche des Substrats vor dem Ätzvorgang mit einer Maskenschicht bzw. Stützschicht zu umgeben, die einen freien Zugang des Ätzmediums bzw. der Ätzmedien zu dem porös zu ätzenden Bereich gestattet bzw. gestatten und die die nicht porös zu ätzenden Bereiche der Deckfläche des Substrats gegen einen Ätzangriff abschirmt.

Gemäß einer bevorzugten Ausführungsform der Erfindung ist die Stützschicht dergestalt, daß sie den porös zu ätzenden Bereich bzw. die porös zu ätzende Schicht der Deckfläche während und nach dem Ätzen der Kaverne am nicht geätzten Teil des Substrats mechanisch fixiert.

Bei einer bevorzugten Ausführungsform der Erfindung wird die Stützschicht vor dem Ätzen des porös zu ätzenden Bereichs bzw. der zu ätzenden Schicht geschaffen, indem zumindest der nächst umliegende Bereich um die porös zu ätzende Schicht der Deckfläche eines p-dotierten Siliziumsubstrats mit einer n-Dotierung versehen wird. Hierdurch kann ein "Unterätzen" des Substrats insbesondere in dem Bereich weitgehend verhindert werden, in dem die porös geätzte Schicht mit dem Siliziumsubstrat mechanisch verbunden ist. Anderenfalls bestünde die Gefahr, insbesondere bei einer bevorzugt dünnen porösen Schicht bzw. Startschicht, daß diese sich vom Substrat ablöst. Zusätzlich kann eine Siliziumnitrid-Schicht als Maskierung und insbesondere zum Schutz gegen einen Ätzangriff von ggf. darunter liegenden elektronischen Schaltungen verwendet werden.

Alternativ oder ergänzend kann anstelle der n-Dotierung bzw. einer n-dotierten Schicht eine Metallschicht oder Metallmaske vorgesehen sein, die ebenfalls ein Unterätzen des Substrats weitgehend verhindert. Die Verwendung einer Metallschicht bzw. Metallmaske wird jedoch in der Regel nur dann zweckmäßig sein, wenn im Substrat keine Schaltkreise vorgesehen werden sollen, da ansonsten im Substrat auch nach dem Entfernen der Metallschicht bzw. Metallmaske verbleibende Metallatome die Funktion der Schaltkreise beeinträchtigen könnten.

Bei einer weiteren bevorzugten Ausführungsform der Erfindung ist vorgesehen, eine porös geätzte Deckschicht, wie insbesondere eine Siliziumschicht, vorzubehandeln, bevor auf diese eine Epitaxieschicht, vorzugsweise eine weitgehend monokristalline Siliziumschicht, aufgebracht bzw. abgeschieden wird. Die Vorbehandlung verfolgt das Ziel, die Poren in der porös geätzten Deckschicht bzw. Startschicht ganz oder teilweise zu verschließen, um die Qualität der weitgehend monokristallinen Siliziumschicht, falls erforderlich oder zweckmäßig, weiter zu verbessern.

Eine erfindungsgemäße Vorbehandlung kann in einer Temperung der porös geätzten Deckschicht bzw. Startschicht bestehen, wobei die Temperung bei einer hohen Temperatur vorgenommen wird, beispielsweise bei einer Temperatur im Bereich von ca. 900 °C bis ca. 1100 °C. Bevorzugt erfolgt die Temperung unter einer Wasserstoff-, Stickstoff- und/oder einer Edelgasatmosphäre.

Alternativ oder ergänzend zur vorgenannten Vorbehandlung kann eine (geringfügige) Oxidierung der porös geätzten Silizium-Startschicht vorgesehen werden. Bevorzugt erfolgt die Oxidierung unter (geringfügiger) Zugabe von Sauerstoff in die Atmosphäre, der die Startschicht im Reaktor ausgesetzt ist, wobei die Oxidierung bevorzugt bei einer Temperatur im Bereich von etwa 400 °C bis 600 °C erfolgt. Unter geringfügig ist eine Oxidierung zu verstehen, die weitgehend lediglich die Poren der Startschicht ganz oder teilweise verschließt und eine etwa netzartige Oxidstruktur bildet. Die Oxidstruktur soll erfindungsgemäß die Oberfläche der porös geätzten Startschicht möglichst wenig bedecken, um dafür zu sorgen, daß sich auf der Startschicht eine möglichst einkristalline Siliziumschicht abscheiden läßt, die die eigentliche Sensormembran bildet. Falls nötig, wird die Oxidierung in einem nachfolgenden Prozeßschritt soweit entfernt, bis dieser erwünschte Zustand eintritt.

Bei einer bevorzugten Ausführungsform der Erfindung ist die Dicke der Startschicht wesentlich kleiner als die Dicke der auf ihr abgeschiedenen Siliziumschicht, so daß das physikalische Verhalten der Sensormembran weitgehend durch die prozeßtechnisch gut in ihrer Dicke einstellbare Siliziumschicht bestimmt ist.

Gemäß einer bevorzugten Ausführungsform der Erfindung wird die gering poröse Schicht bzw. Startschicht für die Abscheidung einer Epitaxieschicht, die beispielsweise die Membran des Drucksensors bildet, mit einem Ätzmedium geätzt, das eine Flußsäure-Konzentration (HF-Konzentration) im Bereich von ca. 20 % bis ca. 50 %, vorzugsweise ca. 30 % bis ca. 40 %, insbesondere ca. 33 %, aufweist.
Bei einer weiteren bevorzugten Ausführungsform der Erfindung, wird die poröse Schicht, die eine Vorstufe des späteren Hohlraums bzw. der Kaverne bildet, mit einem Ätzmedium geätzt, das eine Flußsäure-Konzentration (HF-Konzentration) im Bereich von ca. 0 % bis ca. 40 %, vorzugsweise ca. 5 % bis ca. 20 %, insbesondere weniger als ca. 20 %, aufweist. Bevorzugt besteht der verbleibende Teil des Ätzmediums, der nicht durch Flußsäure gebildet ist, weitgehend aus einem Alkohol, wie insbesondere Äthanol.
Um während eines vorgenannten erfindungsgemäßen Ätzschritts zur Bildung eines Hohlraums bzw. einer Kaverne eine hohe Ausdehnungsgeschwindigkeit der Poren bzw. Hohlräume in der zu zersetzenden Schicht zu erreichen, bei der die Poren bzw. Hohlräume sehr rasch miteinander "überlappen" und so eine einzige "Riesenpore" bilden, ist bei einer erfindungsgemäßen Ausführungsform der Erfindung ein erfindungsgemäßes Ätzmedium vorgesehen. Das erfindungsgemäße Ätzmedium weist eine Flußsäure-Konzentration (HF-Konzentration) im Bereich von ca. 0 % bis ca. 5 %, vorzugsweise ca. 1 % bis ca. 3 %, insbesondere weniger als ca. 5 % auf. Bevorzugt besteht der verbleibende Teil dieses Ätzmediums, der nicht durch Flußsäure gebildet ist, weitgehend aus einem Alkohol, wie insbesondere Äthanol, und/oder aus gereinigtem Wasser.

### Zeichnungen

Das erfindungsgemäße Verfahren zur Herstellung eines erfindungsgemäßen Drucksensoren unter Verwendung von schematischen, nicht notwendigerweise maßstäblichen Zeichnungen näher erläutert, wobei gleiche Bezugszeichen gleiche oder gleichwirkende Schichten oder Teile bezeichnen. Es zeigt:
Fig. 1 eine erste bevorzugte Variante einer Vorstufe eines erfindungsgemäßen Drucksensors nach der Erzeugung einer Siliziummembran mit geringer Porosität in einem Siliziumsubstrat mit einer unter der Siliziummembran liegenden porösen Siliziumschicht mit demgegenüber hoher Porosität - im Querschnitt;
Fig. 2 die in Fig. 1 dargestellte erste Vorstufe, nachdem die unter der Siliziummembran liegende Siliziumschicht mit hoher Porosität zu einem Hohlraum geworden ist - im Querschnitt;
Fig. 3 eine erste Variante einer auf der Grundlage der in Fig. 2 dargestellten Vorstufe hergestellte weitere Vorstufe eines Drucksensors, nachdem die poröse Siliziummembran vorbehandelt und dann mit einer Epitaxieschicht versehen worden ist, die die eigentliche Membran des Drucksensors bildet - im Querschnitt;
Fig. 4 eine zweite Variante einer auf der Grundlage der in Fig. 2 dargestellten Vorstufe hergestellte weitere Vorstufe eines Drucksensors, nachdem die poröse Siliziummembran mit einer Epitaxieschicht versehen worden ist, die die eigentliche Membran des Drucksensors bildet - im Querschnitt;
Fig. 5 einen auf der Basis der in den Figuren 3 oder 4 dargestellten Vorstufe hergestellten Absolutdrucksensor, der mit monokristallinen, piezoresistiven Widerständen und dotierten Zuleitungen versehen worden ist - im Querschnitt;
Fig. 6 den in Fig. 5 dargestellten Absolutdrucksensor, der mit im Sensor integrierten Schaltungen versehen worden ist - im Querschnitt;
Fig. 7 eine erste Variante eines erfindungsgemäßen Differenzdrucksensors (nicht in der Erfindung) mit einer Zugangsöffnung und einem lateralen Kanal zum Hohlraum - im Querschnitt;
Fig. 8 den Umriß des Membranbereichs des in Fig. 7 dargestellten Differenzdrucksensors - in Draufsicht; (nicht in der Erfindung)
Fig. 9 eine zweite Variante eines erfindungsgemäßen Differenzdrucksensors (nicht in der Erfindung) mit einer Zugangsöffnung zum Hohlraum - im Querschnitt;
Fig. 10 eine Vorstufe einer dritten Variante eines erfindungsgemäßen Differenzdrucksensors (nicht in der Erfindung) mit einer einzigen dicken porösen Schicht - im Querschnitt;
Fig. 11 die in Fig. 10 dargestellte Vorstufe mit einer ersten Zugangsöffnung - im Querschnitt; (nicht in der Erfindung)
Fig. 12 die in Fig. 10 dargestellte Vorstufe mit einer zweiten Zugangsöffnung - im Querschnitt; (nicht in der Erfindung)
Fig. 13 eine Vorstufe einer vierten Variante eines erfindungsgemäßen Differenzdrucksensors (nicht in der Erfindung) mit einer porösen Schicht, die sich bis zur Unterseite des Substrats erstreckt - im Querschnitt;
Fig. 14 die in Fig. 13 dargestellte Vorstufe, nachdem die sich bis zur Unterseite des Substrats erstreckende poröse Schicht entfernt worden ist - im Querschnitt;
Fig. 15 eine Vorstufe eines erfindungsgemäßen kapazitiven Absolutdrucksensors - im Querschnitt;
Fig. 16 die in Fig. 15 dargestellte Vorstufe nach der Erzeugung einer porösen Siliziummembran mit einem unter der Siliziummembran liegenden Hohlraum - im Querschnitt;
Fig. 17 eine erste Variante einer Vorstufe eines Drucksensors mit Widerständen, deren Widerstand sich aufgrund der Durchbiegung einer Membran des Drucksensors bei Druckbeaufschlagung ändert- im Querschnitt;
Fig. 18 eine zweite Variante einer Vorstufe eines Drucksensors mit Widerständen, deren Widerstand sich aufgrund der Durchbiegung einer Membran des Drucksensors bei Druckbeaufschlagung ändert- im Querschnitt;
Fig. 19 die in Fig. 17 dargestellte Vorstufe nach der Erzeugung einer porösen Siliziummembran in der auf dem Siliziumsubstrat abgeschiedenen Silizium-Epitaxieschicht mit einem unter der Siliziummembran liegenden Hohlraum - im Querschnitt;
Fig. 20 die in Fig. 19 dargestellte weitere Vorstufe, nachdem die poröse Siliziummembran mit einer Verschlußschicht versehen worden ist - im Querschnitt;
Fig. 21 eine erste Variante eines Differenzdruck-sensors, (nicht in der Erfindung) der auf der Basis des in Fig. 20 dargestellten Absolutdrucksensors hergestellt worden ist - im Querschnitt; und
Fig. 22 eine zweite Variante eines Differenzdruck-sensors, (nicht in der Erfindung) der auf der Basis des in Fig. 20 dargestellten Absolutdrucksensors hergestellt worden ist - im Querschnitt.

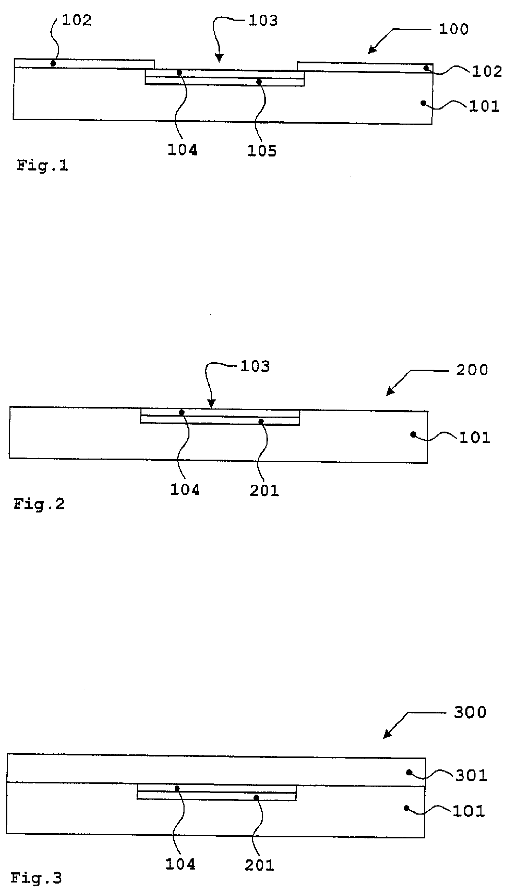

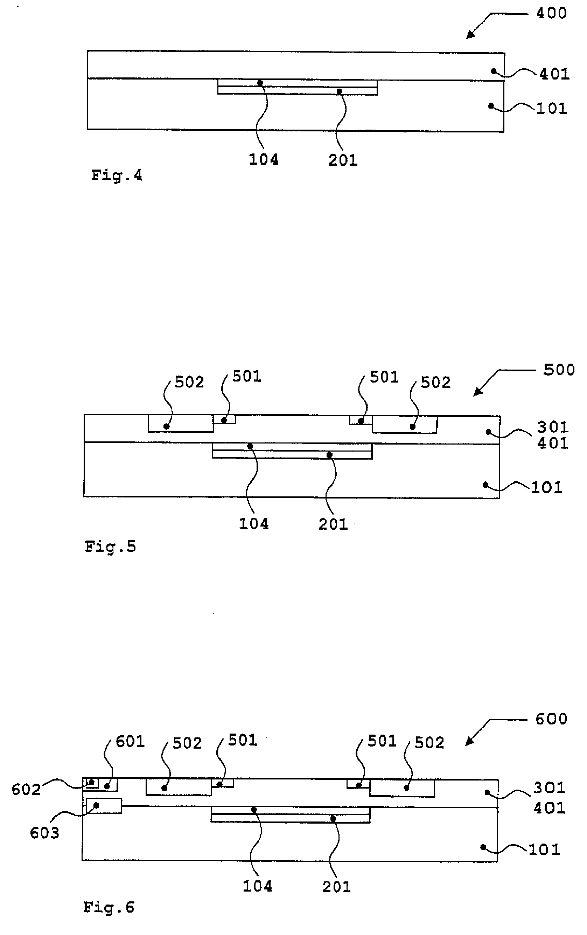

Fig. 1 zeigt eine bevorzugte Variante einer Vorstufe 100 des in Fig. 5 dargestellten Absolutdrucksensors 500 - im Querschnitt. Zur Herstellung des in Fig. 5 dargestellten Absolutdrucksensors 500 wird zunächst auf der Oberseite eines Siliziumsubstrats 101 eine Maskenschicht 102 erzeugt, wobei ein nicht durch die Maskenschicht 102 abgedeckter Bereich 103 entsteht. Bei der Maskenschicht kann es sich beispielsweise um eine Nitridschicht, eine n-dotierte Schicht (bei p-dotiertem Siliziumsubstrat) oder eine sonstige geeignete Schicht handeln, die von dem nachfolgend verwendeten Ätzmedium weitgehend nicht angegriffen wird.

Die Oberseite des Siliziumsubstrats 101 wird elektrochemisch unter Verwendung eines geeigneten Ätzmediums derart geätzt, daß das Ätzmedium unmittelbar unter dem nicht abgedeckten Bereich 103 kleine Öffnungen bzw. Poren in dem Siliziumsubstrat 101 erzeugt. Es entsteht eine Siliziumschicht 104 mit geringer Porosität. Durch diese kleinen Öffnungen bzw. Poren der Siliziumschicht 104 gelangt das Ätzmedium in tiefer gelegene Bereiche des Siliziumsubstrats 101 und bildet ebenfalls Poren in dem dort befindlichen Silizium. Hierbei entsteht eine poröse Siliziumschicht 105 unterhalb der porösen Siliziumschicht 104.

Bei dem Ätzmedium zum elektrochemischen Ätzen, wie insbesondere Naßätzen, handelt es sich bevorzugt um Flußsäure (HF) oder um ein Ätzmedium, das u. a. Flußsäure (HF) enthält. Erfindungsgemäß wird bevorzugt ein elektrisches Feld zwischen der Oberseite und der Unterseite des Siliziumsubstrats 101 erzeugt, wobei über die eingestellte elektrische Feldstärke bzw. die eingestellte elektrische Stromdichte die Ausdehnungsgeschwindigkeit der Poren bzw. Öffnungen bzw. Hohlräume beeinflußt wird.

Bei einem bevorzugten elektrochemischen Ätzverfahren gemäß der Erfindung, werden zu ätzende Vorstufen der Drucksensoren in ein wannenförmiges Gefäß gegeben, das mit dem Ätzmedium gefüllt ist, und es wird eine elektrische Spannung derart an gegenüberliegenden Enden des Ätzmediums angelegt, daß das elektrische Feld entsteht.

Um dafür zu sorgen, daß die poröse Siliziumschicht 104 im Bereich unmittelbar unter dem von der Maskenschicht 102 ausgesparten Bereich 103 entsteht, wird nach dem Aufbringen des Ätzmediums auf den nicht abgedeckten Bereich 103 in einem ersten Schritt eine nicht notwendigerweise konstante elektrische Stromdichte eingestellt. Sie ist vorzugsweise derart gewählt, daß unmittelbar unter dem nicht abgedeckten Bereich 103 Öffnungen bzw. Poren im Siliziumsubstrat 101 entstehen.

Ein weiteres, wichtiges Kriterium für die in dem ersten Schritt eingestellte, nicht notwendigerweise konstante elektrische Stromdichte besteht darin, eine solche elektrische Stromdichte einzustellen, bei der geeignete Öffnungen bzw. Poren im Siliziumsubstrat 101 unmittelbar unter dem nicht abgedeckten Bereich 103 entstehen. Geeignet sind insbesondere solche Öffnungen bzw. Poren, die es nachfolgend gestatten auf der während des Ätzvorgangs gebildeten porösen Siliziumschicht 104 eine weitgehend monokristalline Siliziumschicht abzuscheiden, die die eigentliche Sensormembran bildet. Daher dürfen die Öffnungen bzw. Poren nur eine adäquate Größe bzw. einen adäquaten Durchmesser aufweisen. Bevorzugte Öffnungen bzw. Poren haben beispielsweise einen Durchmesser von ca. 10 bis 100 nm, vorzugsweise ca. 10-30 nm.

Es versteht sich, daß dies lediglich ein Beispiel für geeignete Öffnungen bzw. Poren ist.

Nachdem das Ätzmedium die poröse Siliziumschicht 104 durchdrungen hat, wird in einem zweiten Schritt bevorzugt die Stromdichte im Vergleich zur Stromdichte während des ersten Schritts erhöht, wodurch die Poren- bzw. Hohlraumausdehnungsgeschwindigkeit gesteigert wird und größere Poren in der Siliziumschicht 105 im Vergleich zu den Poren in der porösen Siliziumschicht 104 entstehen.

Das von dem Ätzmedium zersetzte Silizium wird während des Ätzvorgangs und/oder nachfolgend über die Öffnungen bzw. Poren in der porösen Siliziumschicht 104 entfernt und "frisches" Ätzmedium herangeführt.

Bei der in Fig. 1 dargestellten bevorzugten ersten Variante des erfindungsgemäßen Verfahrens zur Herstellung der Vorstufe eines Drucksensors bzw. eines Hohlraums, wird der Ätzvorgang zur Herstellung des späteren Hohlraums 201 (Fig. 2) durch die Wahl geeigneter Prozeßparameter und/oder eines oder mehrerer geeigneter Ätzmedien derart eingestellt, daß die Porosität der Siliziumschicht 105, die den späteren Hohlraum 201 bildet, ausreichend groß ist. Unter "ausreichend" wird bevorzugt eine Porosität verstanden, die größer als 80 Prozent und kleiner als 100 Prozent ist. Nachfolgend wird eine Temperung vorgenommen. Die Temperung erfolgt bevorzugt unter einer Wasserstoff-, Stickstoff- oder Edelgasatmosphäre und/oder bei einer Temperatur von über ca. 900 °C. Aufgrund der hohen Porosität der Siliziumschicht 105 ordnen sich bei der Temperung die Poren so um, daß unter der gering porösen Siliziumschicht 104 eine einzelne große Pore entsteht, also der in Fig. 2 dargestellte Hohlraum bzw. die dargestellte Kaverne 201. Die Poren auf der Oberseite der gering porösen Siliziumschicht 104 werden bei der Temperung bzw. dem Hochtemperaturschritt weitgehend verschlossen, so daß auf dieser die eigentliche Sensormembran als weitgehend monokristalline Siliziumschicht abgeschieden werden kann.

Bei einer nicht dargestellten, ebenfalls bevorzugten erfindungsgemäßen zweiten Variante zur Erzeugung der Vorstufe eines Drucksensors bzw. eines Hohlraums 201 werden die Prozeßparameter nach der Bildung der Siliziumschicht 104 geringer Porosität derart eingestellt, daß die Ausdehnungsgeschwindigkeit der Poren bzw. Hohlräume innerhalb einer dünnen Übergangsschicht unter der Siliziumschicht 104 stark ansteigt, wobei die Poren in dieser Übergangsschicht zusammenwachsen bzw. einander quasi "überlappen". Mit anderen Worten: Die Übergangsschicht ist ein zunächst flächenhafter Hohlraum, der während des weiteren Ätzvorgangs in die Tiefe wächst und schließlich den Hohlraum bzw. die Kaverne 201 bildet. D. h. es werden nicht erst Poren geätzt und dann vergrößert, sondern die Übergangsschicht, eine flächenhafte "Riesenpore" mit zunächst geringer Dicke, wächst langsam in die Tiefe.
Erfindungsgemäß wird das Ätzmedium und/oder die Ätzmedien bevorzugt mit einem leicht flüchtigen Bestandteil versehen. Vorzugsweise wird ein Alkohol verwendet, wie beispielsweise Äthanol.

Falls erforderlich oder zweckmäßig, ist erfindungsgemäß vorgesehen, den porös zu ätzenden Bereich der Deckfläche des Substrats 101 mit einer Maskenschicht und/oder Stützschicht zu versehen, die die porös zu ätzende Schicht der Deckfläche, d. h. die Siliziumschicht 104, während und nach dem Ätzen bzw. während der Schaffung des Hohlraums 201 an den Verbindungsstellen im Bereich der nicht geätzten Deckfläche des Substrats mechanisch fixiert (nicht dargestellt).

Eine solche Stützschicht kann beispielsweise geschaffen werden, indem zumindest der nächst umliegende Bereich um die porös zu ätzende Siliziumschicht 104 der Deckfläche des p-dotierten Siliziumsubstrats 101 mit einer n-Dotierung versehen wird. Hiermit kann ein "Unterätzen" des Siliziumsubstrats 101 im Bereich der Verbindungsstellen bzw. Grenzflächen zwischen der Siliziumschicht 104 und dem Siliziumsubstrat 101 weitgehend verhindert werden. Ferner kann dafür Sorge getragen werden, daß auch eine bevorzugt dünne poröse Siliziumschicht 104, die die Startschicht einer Silizium-Epitaxieschicht 301 bzw. 401 (Fig. 3 und 4) bildet, sicher am Siliziumsubstrat 101 befestigt ist.

Fig. 3 zeigt eine erste Variante einer auf der Grundlage der in Fig. 2 dargestellten Vorstufe geschaffenen weiteren Vorstufe des Absolutdrucksensors 500 im Querschnitt, der in Fig. 5 dargestellt ist, nachdem die poröse Siliziummembran bzw. Siliziumschicht 104 vorbehandelt und dann mit einer weitgehend monokristallinen Silizium-Epitaxieschicht 301 versehen worden ist. Der Druck, der bei dem Epitaxieprozeß bzw. bei der Abscheidung der Epitaxieschicht 301 herrscht, definiert den im Hohlraum 201 eingeschlossenen Druck.

Eine bevorzugte erfindungsgemäße Vorbehandlung besteht aus einer Temperung der porösen Siliziumschicht 104. Bevorzugt wird die Temperung bei einer hohen Temperatur vorgenommen, wie beispielsweise bei einer Temperatur im Bereich von ca. 900 °C bis ca. 1100 °C und/oder die Temperung wird unter einer Wasserstoff-, Stickstoff- und/oder Edelgasatmosphäre vorgenommen.

Die Vorbehandlung erlaubt es die Poren in der porös geätzten, monokristallinen Siliziumschicht 104 weitgehend zu verschließen, so daß auf dieser eine weitgehend monokristalline Silizium-Epitaxieschicht 301 abgeschieden werden kann. Es versteht sich, daß auf eine solche Vorbehandlung, insbesondere aus Kostengründen, verzichtet werden kann, wenn die Qualität der abgeschiedenen Siliziumschicht auch ohne Vorbehandlung zufriedenstellend ist.

Fig. 4 zeigt demgegenüber eine zweite Variante einer auf der Grundlage der in Fig. 2 dargestellten Vorstufe hergestellten weiteren Vorstufe des in Fig. 5 gezeigten Absolutdrucksensors 500 im Querschnitt, nachdem die poröse Siliziummembran bzw. Siliziumschicht 104 ohne Vorbehandlung mit einer ebenfalls weitgehend monokristallinen Silizium-Epitaxieschicht 401 versehen worden ist. Diese bildet wiederum die eigentliche Membran des Drucksensors. Der Druck, der bei dem Epitaxieprozeß bzw. bei der Abscheidung der Epitaxieschicht 401 herrscht, definiert, wie bei der Abscheidung der Epitaxieschicht 301, den im Hohlraum 201 eingeschlossenen Druck.
Beim Epitaxieprozeß mit Wasserstoff als Trägergas zur Herstellung der Epitaxieschicht 301 bzw. 401 wird hauptsächlich Wasserstoff im Hohlraum 201 eingeschlossen. Findet die Epitaxie in etwa bei Atmosphärendruck und damit bei gegenüber niedrigeren Prozeßdrücken höheren Wachstumsraten statt, so beträgt der eingeschlossene Wasserstoffdruck etwa 1 bar. Bei einem erfindungsgemäßen Hochtemperaturschritt, z. B. unter einer Stickstoffatmosphäre, diffundiert der Wasserstoff aufgrund seiner geringen Molekülgröße und aufgrund des Gradienten der Wasserstoffkonzentration insbesondere durch die im Verhältnis zum Substrat in der Regel dünnere Epitaxieschicht 301 bzw. 401. Hierdurch entsteht in der Kaverne 201 nahezu ein Vakuum. Ein solcher erfindungsgemäßer Verfahrensschritt ist insbesondere bei der Herstellung eines Absolutdrucksensors zweckmäßig. Dessen Hohlraum weist in der Regel einen gegenüber der Atmosphäre verminderten Druck auf, wie insbesondere Vakuum. Ferner kann es zweckmäßig sein, den erfindungsgemäßen Hochtemperaturschritt unter einer Wasserstoffatmosphäre auszuführen, wobei der Druck der Wasserstoffatmosphäre vorzugsweise auf den Druck eingestellt wird, der in der Kaverne bzw. im Hohlraum des Absolutdrucksensors erwünscht ist.
Es versteht sich, daß die vorstehende Verfahrensweise zur Herstellung eines weitgehenden Vakuums in der Kaverne 201 auch bei Epitaxieprozessen mit Wasserstoff als Trägergas unter höheren oder niedrigeren Gesamtdrücken als etwa 1 bar Verwendung finden kann.
In Fig. 5 ist ein auf der Basis der in den Figuren 3 oder 4 dargestellten Vorstufe hergestellter Absolutdrucksensor 500 im Querschnitt gezeigt. Bei dem Absolutdrucksensor 500 sind auf der weitgehend monokristallinen Silizium-Epitaxieschicht 301 bzw. 401 in bekannter Weise monokristalline, piezoresistive Widerstände 501 und Zuleitungen 502 aus dotiertem Silizium erzeugt worden.
In Fig. 6 ist ein auf der Basis des in Fig. 5 dargestellten Absolutdrucksensors 500 hergestellter Absolutdrucksensor 600 im Querschnitt gezeigt. Der in Fig. 5 dargestellte Absolutdrucksensor 500 ist in bekannter Weise mit integrierten Schaltungen 601, 602 und 603 versehen worden.

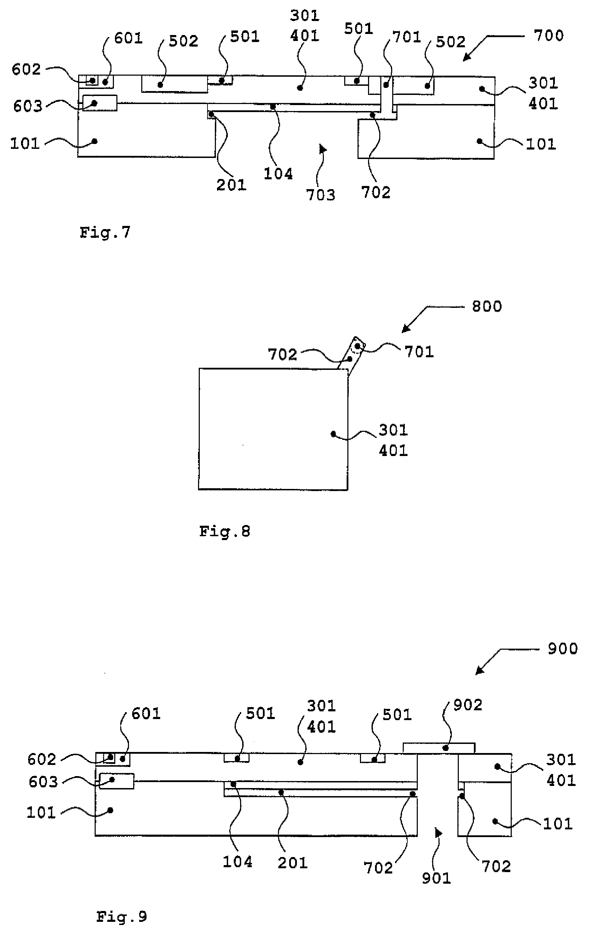

Fig. 7 zeigt eine erste Variante eines Differenzdrucksensors (nicht in der Erfindung) 700 - im Querschnitt - mit einer Zugangsöffnung 701 zum Hohlraum bzw. zur Kaverne 201 über einen lateralen Kanal 702. Die in Fig. 7 dargestellte Differenzdrucksensors 700 ist wie der in Fig. 6 dargestellte Absolutdrucksensor 600 hergestellt worden.
Für einen Differenzdrucksensor ist es wünschenswert, Druck von der Rückseite der Membran bzw. der Epitaxieschicht 301 bzw. 401 zuführen zu können. Dazu ist es notwendig, durch geeignete Ätztechniken eine Öffnung 703 von der Rückseite der Membran bzw. des Substrats 101 zu erzeugen. Eine vorzugsweise weitgehend senkrechte Wände aufweisende Öffnung 703 kann beispielsweise durch Trockenätzen, wie Plasmaätzen oder Trenchätzen, erzeugt werden. Plasmaätzen oder Trenchätzen stoppt auf Oxidschichten. Eine Oxidation des Hohlraums 201 vor der Abscheidung der Silizium-Epitaxieschicht 301 bzw. 401 ist jedoch nicht möglich, da dann auf der gering porösen Siliziumschicht bzw. Startschicht 104 eine nicht erwünschte polykristalline Epitaxieschicht aufwachsen würde.

Liegt die Zugangsöffnung 701 außerhalb des Membranbereichs, wie im Ausführungsbeispiel gemäß der Figuren 7 und 8, muß in der Maskenschicht 102 der laterale Kanal 702 berücksichtigt und der laterale Kanal 702 zusammen mit dem Hohlraum bzw. mit der Kaverne 201 in der beschriebenen Weise erzeugt werden.

Nach der Abscheidung der Epitaxieschicht 301 bzw. 401 werden beispielsweise durch Trockenätzen ein oder mehrere Löcher bzw. Öffnungen 701 von der Oberseite der Epitaxieschicht bis zum Hohlraum 201 erzeugt. Dies kann (nicht dargestellt) entweder direkt im Membranbereich (der Bereich der Epitaxieschicht 301 bzw. 401 oberhalb der Öffnung 703, vgl. auch Fig. 8) oder außerhalb der Membran erfolgen, wie in den Figuren 7 und 8 dargestellt.

Nach der Herstellung des Hohlraums 201, des lateralen Kanals 702 sowie der Zugangsöffnung 701 werden die Wände des Hohlraums bzw. der Kaverne 201, des lateralen Kanals 702 und der Zugangsöffnung 701 in bekannter Weise in einem Oxidationsschritt oxidiert.

Der Oxidationsschritt ist möglicherweise bereits für die Erzeugung von Schaltungselementen notwendig und erfordert ggf. keinen zusätzlichen Aufwand. Bei geeigneter Wahl der Größe der Zugangsöffnung 701 wird diese bereits durch den Oxidationsschritt verschlossen. Ansonsten kann die Zugangsöffnung 701 durch einen speziellen Verschlußschritt oder durch das Ausnutzen weiterer, zur Erzeugung von Schaltungselementen notwendiger Prozeßschritte verschlossen werden, wie beispielsweise durch die Abscheidung von Oxid, Nitrid, Metall, usw..

In einem nachfolgenden Verfahrensschritt wird die Öffnung 703 von der Unterseite des Substrats bzw. Wafers 101 durch Trockenätzen, wie insbesondere Trenchätzen, gebildet. Dieser Ätzprozeß stoppt auf der Oxidschicht, die den Hohlraum von unten begrenzt. Durch einen sich hieran anschließenden Ätzschritt, wie ein Trockenätzschritt oder ein naßchemischer Ätzschritt, wird die den Hohlraum von unten begrenzende dünne Oxidschicht und eine ggf. auf der Rückseite des Wafers vorhandene Oxidmaske entfernt und der Hohlraum bzw. die Kaverne 201 geöffnet.

Fig. 9 zeigt eine zweite Variante eines Differenzdrucksensors 900 (nicht in der Erfindung) mit einer Zugangsöffnung 901 zum Hohlraum 201 - im Querschnitt. Wie im Zusammenhang mit den Figuren 7 und 8 beschrieben, wird ein lateraler Kanal 702 erzeugt. Anstelle der Zugangsöffnung 701 bei der in den Figuren 7 und 8 dargestellten ersten Variante wird bei dem in Fig. 9 dargestellten Differenzdrucksensor 900 eine Oxid-Stopschicht 902 zumindest oberhalb des lateralen Kanals 702 auf der Epitaxieschicht 301 bzw. 401 abgeschieden. Analog zu der im Zusammenhang mit den Figuren 7 und 8 beschriebenen Weise, wird in einem nachfolgenden Ätzschritt eine Öffnung 901, wie insbesondere durch Trenchätzen, unterhalb der Oxid-Stopschicht 902 erzeugt. Der Ätzprozeß stoppt dabei im Bereich des lateralen Kanals 702 auf der Unterseite der Oxid-Stopschicht 902, die sich oberhalb der Epitaxieschicht 301 bzw. 401 befindet.
Zur Erhöhung der Stabilität der Epitaxieschicht 301 bzw. 401 kann die Oxid-Stopschicht 902 durch weitere Schichten verstärkt werden. Ebenso ist es denkbar keinen lateralen Kanal zu verwenden, sondern die Öffnung im Membranbereich vorzusehen (nicht dargestellt).

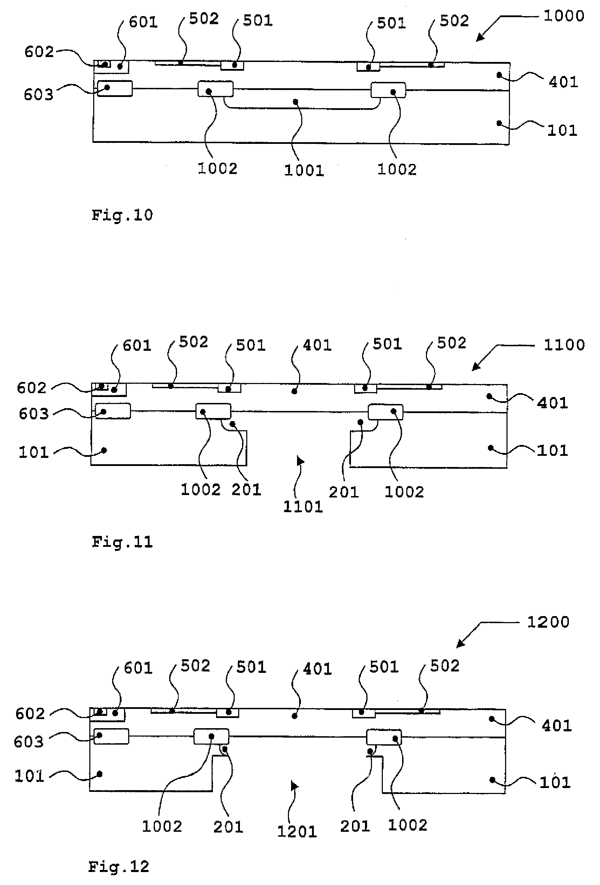

Fig. 10 zeigt eine Vorstufe 1000 einer dritten Variante eines Differenzdrucksensors 1100 (nicht in der Erfindung) bzw. 1200 mit einer einzigen dicken porösen Schicht 1001 - im Querschnitt. Die dicke poröse Schicht 1001 wird in analoger Weise wie insbesondere im Zusammenhang mit den Figuren 1 bis 4 erläutert erzeugt. Die poröse Schicht 1001 ist jedoch vorzugsweise deutlich dicker als die gering poröse Siliziumschicht 104. Im Unterschied zu den Differenzdrucksensoren 700 und 900 ist die Bildung eines Hohlraums bzw. einer Kaverne 201 vor der Bildung eines einseitig offenen Hohlraums 1101 bzw. 1201 (vgl. Figuren 11 und 12) nicht notwendig. Die mit 1002 bezeichneten Bereiche sind dotierte Bereiche des Substrats 101, die eine Unterätzung am Rand der Membran, die sich über dem einseitig offenen Hohlraum (vgl. Fig. 11 bis 14) erstreckt, begrenzen. Dies ist aufgrund der hohen Ätztiefe zur Erzeugung der dicken porösen Schicht 1001, wie beispielsweise ca. 50 µm, sinnvoll. Die Membran wird dadurch am Membranrand etwas steifer.

Ausgehend von der in Fig. 10 dargestellten Vorstufe eines Differenzdrucksensors (nicht in der Erfindung) 1100 bzw. 1200, wird mit isotropen oder anisotropen Ätztechniken, bevorzugt mit Hochratentrenchen, von der Rückseite des Substrats bzw. Wafers 101 der einseitig offene Hohlraum 1101 bzw. 1201 hergestellt.

Aufgrund der in der dicken porösen Schicht 1001 vorhandenen Poren kann diese selektiv zum umgebenden Substratmaterial durch Ätzlösungen oder Ätzgase herausgelöst werden. Dieses Herauslösen kann im gleichen Prozeßschritt wie das Ätzen der Zugangsöffnung zur Rückseite der Sensormembran und zur Bildung des einseitig offenen Hohlraums 1101 bzw. 1201 erfolgen.
Die Breite des einseitig offenen Hohlraums 1101 ist geringer als die Breite des Membranbereichs bzw. als die Breite der porösen Schicht 1001, wohingegen die Breite des einseitig offenen Hohlraums 1201 größer als die Breite des Membranbereichs bzw. als die Breite der porösen Schicht 1001 ist.

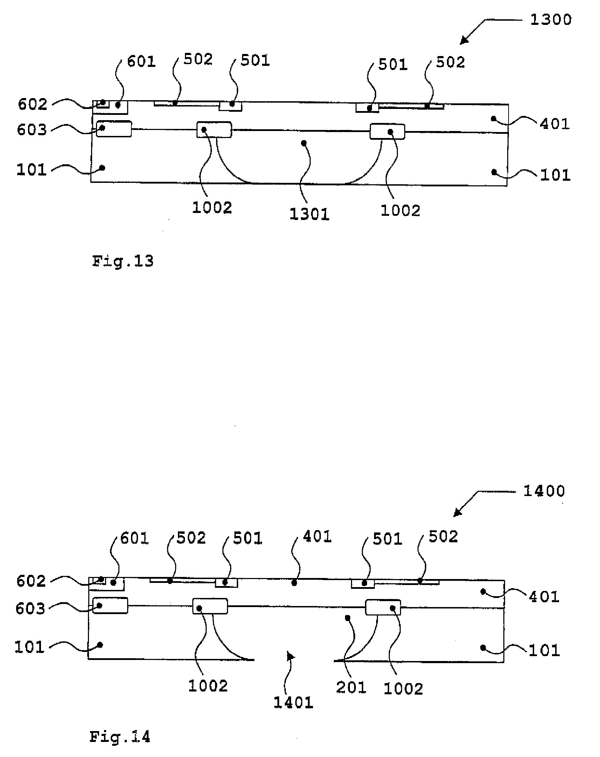

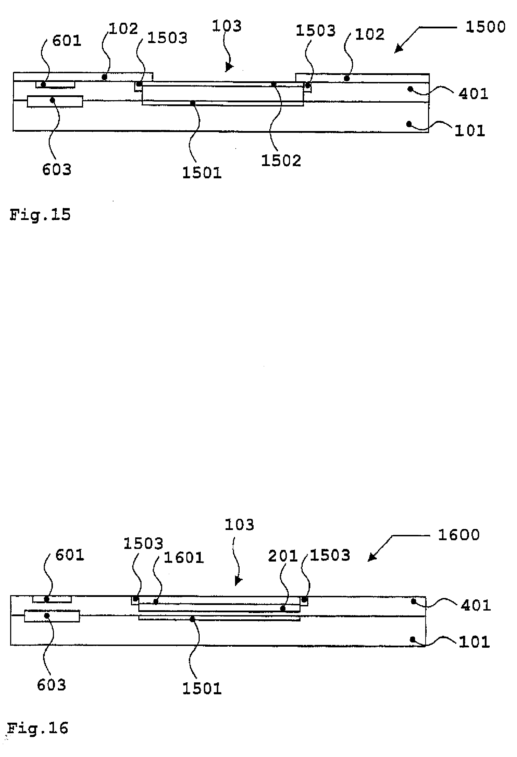

Fig. 13 zeigt eine Vorstufe 1300 einer vierten Variante eines Differenzdrucksensors (nicht in der Erfindung) 1400 im Querschnitt. Bei der Vorstufe 1300 erstreckt sich die poröse Schicht 1301, im Unterschied zu der in Fig. 10 dargestellten Vorstufe, bis zur Unterseite des Substrats 101. Die poröse Schicht 1301 kann in der im Zusammenhang mit den Figuren 10 bis 12 genannten Weise selektiv entfernt werden, ohne daß eine Zugangsöffnung geätzt werden muß. Nach der selektiven Entfernung der porösen Schicht 1301 befindet sich unter der Sensormembran bzw. der Epitaxieschicht 401 ein einseitig offener Hohlraum 1401. Durch Standardhalbleiterprozesse wird die in Fig. 15 im Querschnitt dargestellte Vorstufe 1500 eines erfindungsgemäßen kapazitiven Absolutdrucksensors 1600 (Fig. 16) hergestellt. Neben integrierten Schaltungen 601 und 603 zur Auswertung der vom kapazitiven Absolutdrucksensors 1600 abgegebenen Meßsignale, ist auf der Oberseite des Siliziumsubstrats 101 in dem Siliziumsubstrat 101 eine vorzugsweise durch eine geeignete Dotierung des Siliziumsubstrats 101 erzeugte Bodenelektrode 1501 und auf der Oberseite des Siliziumsubstrats 101 und der Bodenelektrode 1501 eine Silizium-Epitaxieschicht 401, die vorzugsweise monokristallin ist, vorgesehen. Auf der Oberseite der Silizium-Epitaxieschicht 401 ist höhenversetzt zur Bodenelektrode 1501 eine vorzugsweise durch eine geeignete Dotierung erzeugte Deckelelektrode 1502 in der Silizium-Epitaxieschicht 401 vorgesehen. Die Oberseite der Silizium-Epitaxieschicht 401 ist außer im Bereich 103 der Deckelelektrode 1502 von einer Maskenschicht 102 zum Schutz gegen einen Ätzangriff abgedeckt.
Der durch die Maskenschicht 102 nicht abgedeckte Bereich 103 wird, wie bereits eingehend beschrieben, porös geätzt, vorzugsweise elektrochemisch, wie insbesondere unter Verwendung von Flußsäure (HF) oder einem Ätzmedium, das Flußsäure enthält. Ausgehend von der Deckelelektrode 1502 entsteht hierbei eine poröse Deckelelektrode bzw. Membran 1601.

Bei der Erfindung wird die Deckelelektrode 1502 aus einer p-dotierten Schicht der ebenfalls p-dotierten Epitaxieschicht 401 gebildet. Eine p-dotierte Schicht wird von dem Ätzmedium porös geätzt. Die Bodenelektrode 1501 kann sowohl durch eine p-dotierte als auch durch eine n-dotierte Schicht gebildet werden.

Bei der Erfindung wird sowohl die Bodenelektrode 1501 als auch die Deckelelektrode 1502 durch eine sieb- bzw. netzartige, n-dotierte Schicht in der p-dotierten Epitaxieschicht 401 bzw. im p-dotierten Substrat 101 gebildet. Die n-dotierten Bereiche der sieb- bzw. netzartigen Schicht sind vorzugsweise sehr schmal, flach und weisen einen geeigneten Abstand zueinander auf, so daß sie gut von dem Ätzmedium zur Bildung der porösen Deckelelektrode 1502 unterätzt werden können.
Eine n-dotierte Schicht wird von dem Ätzmedium weitgehend nicht angegriffen, und das Ätzmedium durchdringt die sieb- bzw. netzartige Schicht der Deckelelektrode 1502 zur Bildung des späteren Hohlraums 201. Der Hohlraum 201 kann insbesondere durch eines der bereits im Zusammenhang mit den Figuren 1 bis 3 beschriebenen Verfahren gebildet werden. Bevorzugt ist auch für die Bodenelektrode 1501 eine sieb- bzw. netzartige, vorzugsweise ebenfalls n-dotierte Schicht vorgesehen. Hierdurch ergibt sich in vorteilhafter Weise ein weitgehend homogenes elektrisches Feld beim elektrochemischen Ätzvorgang.
Ein auf die Deckelelektrode 1502 des Absolutdrucksensors wirkender äußerer Druck biegt die Deckelelektrode 1502 zur Bodenelektrode 1501 hin, wodurch sich die Kapazität des durch die beiden Elektroden gebildeten Kondensators ändert. Die elektronisch auswertbare Kapazität ist ein Maß für den auf die Deckelelektrode wirkenden Absolutdruck.
Um ein Unterätzen der Epitaxieschicht 401 im Kontaktbereich mit der porösen Deckelelektrode 1502 zu verhindern, ist der Kontaktbereich um die poröse Deckelelektrode 1502 bevorzugt n-dotiert, wodurch die mit 1503 bezeichneten n-dotierten Bereiche entstehen.
Bei einer ersten Ausführungsform der Erfindung wird nachfolgend auf der porösen Deckelelektrode bzw. Membran 1601 eine Verschlußschicht (nicht dargestellt) abgeschieden, z. B. eine Nitridschicht. Der bei der Abscheidung herrschende Druck definiert den Druck im Hohlraum bzw. in der Kaverne 201 (vgl. die vorstehenden Ausführungen zu diesem Punkt). Bei einer Druckänderung verändert sich der Abstand zwischen der Deckelelektrode und der Bodenelektrode und damit die Kapazität. Die Kapazitätsänderung wird durch die integrierten Schaltungen 601 und 603 ausgewertet.

Bei einer zweiten Ausführungsform der Erfindung wird die Membran 1601 durch einen Oxidationsschritt und/oder eine Verschlußschicht (nicht dargestellt), wie z. B. eine Oxidschicht, verschlossen. Auf der oxidierten Membran 1601 bzw. auf der Verschlußschicht wird eine weitere Schicht (nicht dargestellt), wie insbesondere eine dotierte Poly-Siliziumschicht oder eine Metallschicht, abgeschieden, die (möglicherweise nach einer Strukturierung) die Funktion einer Deckelelektrode hat. Ebenso kann die Deckelelektrode beispielsweise in Form eines dotierten Bereichs in der weiteren Schicht, wie insbesondere in einer undotierten Poly-Siliziumschicht, vorgesehen sein.

Sowohl bei der ersten als auch bei der zweiten Ausführungsform können weitere Schichten abgeschieden und strukturiert werden, beispielsweise um eine Versteifung der Membran 1601, insbesondere im mittleren Membranbereich, zu erreichen.

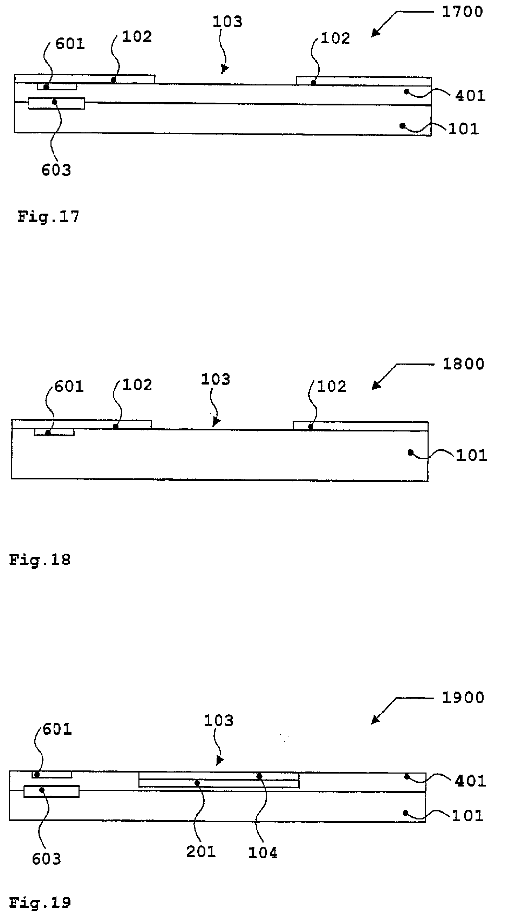

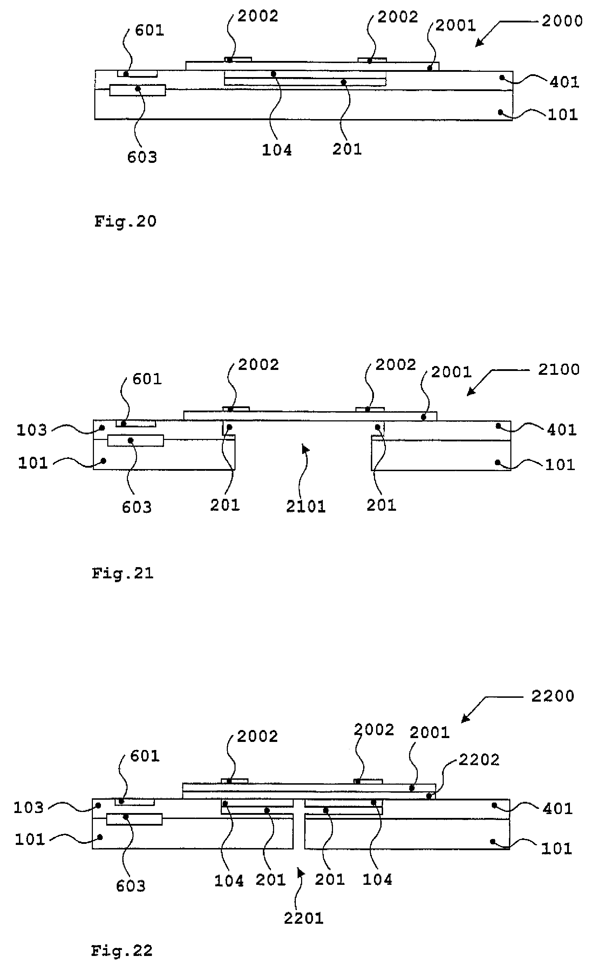

Fig. 17 zeigt eine erste Variante einer Vorstufe 1700 eines Absolutdrucksensors 2000 (vgl. Fig. 20) mit Widerständen, wie insbesondere polykristallinen piezoresistiven Widerständen oder Metalldünnschichtwiderständen - im Querschnitt. Die durch Standardhalbleiterprozesse gebildete Vorstufe 1700 für die in Fig. 19 dargestellte weitere Vorstufe 1900, weist ein Siliziumsubstrat 101, eine auf dem Siliziumsubstrat 101 abgeschiedene Silizium-Epitaxieschicht 401 und eine auf der Oberseite der Silizium-Epitaxieschicht 401 aufgebrachte Maskenschicht 102 auf. Die Maskenschicht 102 ist mit einem nicht abgedeckten Bereich 103 versehen. Ferner ist in der Oberseite der Silizium-Epitaxieschicht 401 und zwischen dem Siliziumsubstrat bzw. Wafer 101 und der Epitaxieschicht 401 jeweils eine integrierte Schaltung 601 bzw. 603 gebildet worden.

Fig. 18 zeigt eine zweite Variante einer Vorstufe 1800 zur Bildung des Absolutdrucksensors 2000 (Fig. 20) im Querschnitt. Die alternative zweite Vorstufe 1800 unterscheidet sich von der in Fig. 17 dargestellten Vorstufe 1700 darin, daß anstelle eines Siliziumsubstrats 101 und einer auf dieser abgeschiedenen Silizium-Epitaxieschicht 401 lediglich ein Siliziumsubstrat bzw. Wafer 101 als Vorstufe zur Bildung des Absolutdrucksensors 2000 (vgl. Fig. 20) dient, der jedoch im Unterschied zu der in Fig. 20 dargestellten Ausführungsform keine Silizium-Epitaxieschicht 401 aufweist.

Mit den vorstehend beschriebenen erfindungsgemäßen Verfahren wird in der Silizium-Epitaxieschicht 401 der Vorstufe 1700 bzw. in dem Siliziumsubstrat 101 der Vorstufe 1800 eine poröse Siliziummembran 104 und ein darunter liegender Hohlraum bzw. eine Kaverne 201 im Bereich 103 erzeugt, wie dies in Fig. 19 für die Vorstufe 1700 dargestellt ist.

Nach der Entfernung der Maskenschicht 102 wird die poröse Membran 104 durch die Abscheidung einer Verschlußschicht 2001, wie z. B. eine Nitrid- , eine Oxid-, eine Poly-Siliziumschicht oder eine monokristalline Siliziumschicht, oder durch Oxidation verschlossen. Der bei der Abscheidung der Verschlußschicht 2001 bzw. bei der Oxidation herrschende Druck definiert den im Hohlraum bzw. in der Kaverne 201 eingeschlossenen Druck (vgl. die vorstehenden Ausführungen zu diesem Punkt). Auf der Verschlußschicht 2001 bzw. auf der oxidierten Membran (nicht dargestellt) werden Widerstände 2002, wie insbesondere polykristalline piezoresistive Widerstände oder Metalldünnschichtwiderstände, erzeugt. Die Erzeugung der Widerstände 2002 kann beispielsweise durch die Abscheidung von Polysilizium auf der Verschlußschicht 2001, eine nachfolgende Dotierung des abgeschiedenen Polysiliziums und ein anschließendes Strukturieren der abgeschiedenen Poly-Siliziumschicht erfolgen (nicht dargestellt). Ferner können die Widerstände 2002 beispielsweise durch die Abscheidung einer Poly-Siliziumschicht und einem strukturierten Dotieren der Poly-Siliziumschicht erzeugt werden (nicht dargestellt). Ebenso ist die Verwendung von Dehnungsmeßstreifen denkbar (nicht dargestellt).

Eine Druckänderung führt zu einer veränderten Durchbiegung in der durch die poröse Siliziumschicht 104 und die Verschlußschicht 2001 über dem Hohlraum bzw. der Kaverne 201 gebildeten Membran. Dies geht mit einer Widerstandsänderung der piezoresistiven Widerstände 2002 einher, die vorzugsweise von den integrierten Schaltungen 601 bzw. 603 oder durch eine separate Schaltung ausgewertet wird.

Aufgrund der größeren Langzeitstabilität von monokristallinen piezoresistiven Widerständen ggü. polykristallinen piezoresistiven Widerständen, werden die Widerstände 2002 in einer Verschlußschicht 2001 erzeugt, die eine monokristalline Siliziumschicht ist.

Alternativ können die druckabhängigen piezoresistiven Widerstände 2002 bei dem in Fig. 20 dargestellten Absolutdrucksensor 2000 durch n-dotierte Widerstände in dem Bereich der Epitaxieschicht 401 gebildet sein, die die spätere poröse Siliziumschicht 104 bildet (nicht dargestellt).

Für einen Differenzdrucksensor (nicht in der Erfindung) es wünschenswert, wenn der Druck von der Rückseite der Membran des Differenzdrucksensors zugeführt werden kann. Um aus dem in Fig. 20 im Querschnitt dargestellten Absolutdrucksensor 2000 einen Differenzdrucksensor 2100 (vgl. Fig. 21) oder einen Differenzdrucksensor 2200 (vgl. Fig. 22) herzustellen, ist es notwendig eine Öffnung 2101 bzw. eine Öffnung 2201 von der Unterseite des Siliziumsubstrats 101 zum Hohlraum bzw. zur Kaverne 201 zu schaffen.

Auch wird die Öffnung 2101 bzw. 2201 bevorzugt durch Trockenätzen, wie insbesondere durch Trenchätzen bzw. Plasmaätzen, erzeugt (vgl. die vorstehenden Ausführungen zur Erzeugung von Öffnungen durch Trockenätzen). Da ein solcher Ätzprozeß auf Oxidschichten stoppt, ist bei der in Fig. 21 dargestellten Ausführungsform eines Differenzdrucksensors 2100 erfindungsgemäß vorgesehen, den Hohlraum bzw. die Kaverne 201 mit einer Oxidschicht zu versehen. Dies wird erreicht, wenn der Hohlraum bzw. die Kaverne 201 durch Oxidation der porösen Siliziumschicht 104 verschlossen wird. Bevorzugt wird auf der oxidierten porösen Siliziumschicht bzw. Membran 104 eine Siliziumschicht abgeschieden, auf oder in der die piezoresistiven Widerstände 2002, insbesondere durch geeignete Dotierung der Siliziumschicht, erzeugt werden. Nachfolgend wird von der Rückseite des Siliziumsubstrats bzw. Wafers 101 im Membranbereich eine Druckzuführung in Form der Öffnung 2101 hergestellt, vorzugsweise mittels eines Trenchätzprozesses. Ein solcher Ätzprozeß stoppt auf der vorzugsweise dünnen Oxidschicht, die den Hohlraum bzw. die Kaverne 201 von unten begrenzt. Durch einen nachfolgenden, geeigneten Trockenätzschritt oder durch einen naßchemischen Ätzschritt kann die Oxidschicht ggf. von der Rückseite des Substrats bzw. Wafers 101 entfernt werden. Bei diesem Schritt wird der Hohlraum bzw. die Kaverne 201 geöffnet.
Bevorzugt ist der Ätzschritt dergestalt, daß sämtliches Oxid aus dem Hohlraum bzw. aus der Kaverne 201 herausgeätzt und somit die oxidierte, poröse Siliziumschicht 104 entfernt wird. Hieran ist von Vorteil, daß die Membrandicke des Differenzdrucksensors 2100 dann nur noch durch die auf der oxidierten, porösen Siliziumschicht 104 abgeschiedene Verschlußschicht 2001 bestimmt wird. Die Schichtdicke der Verschlußschicht 2001 kann in vorteilhafter Weise sehr genau und reproduzierbar eingestellt werden, was die Herstellung von Differenzdrucksensoren mit reproduzierbaren Eigenschaften deutlich erleichtert.

Fig. 22 zeigt eine zweite Variante eines Differenzdrucksensors, (nicht in der Erfindung) der auf der Basis des in Fig. 20 dargestellten Absolutdrucksensors 2000 hergestellt worden ist, im Querschnitt, wobei im Unterschied zu der in Fig. 20 dargestellten Vorstufe zwischen der Oberseite der Silizium-Epitaxieschicht 401 und der Verschlußschicht 2001 zusätzlich eine Oxidschicht 2202 vorgesehen ist. In analoger Weise wie bei Fig. 21 wird eine Öffnung 2201, vorzugsweise durch Trenchätzen, erzeugt. Der Ätzprozeß stoppt dabei auf der Oxidschicht 2202 und die Druckzuführung zum Hohlraum bzw. zur Kaverne 201 wird geschaffen.

Für den Fall, daß die Verschlußschicht 2001 durch eine Oxidschicht gebildet ist, kann ggf. auf eine zusätzliche Oxidschicht 2202 verzichtet werden. Dies gilt insbesondere, wenn die Stabilität der Verschlußschicht 2001, die als Membran des Differenzdrucksensors dient, ausreichend ist.

## Patentansprüche

1. Verfahren zur Herstellung eines kapazitiven Absolutdrucksensors (1500, 1600), insbesondere mittels eines mehrschichtigen Halbleiterbauelements, wobei ein p-dotiertes Siliziumsubstrat (101) mit wenigstens einer p-dotierten Silizium-Epitaxieschicht (401) vorgesehen ist,
**dadurch gekennzeichnet, daß**
in einem ersten Schritt zur Bildung einer Bodenelektrode (1501) eine sieb- bzw. netzartige n-dotierte Schicht im p-dotierten Siliziumsubstrat (101) und zur Bildung eines Deckelelektrode (1502) eine sieb- bzw. netzartige n-dotierte Schicht in der p-dotierten Silizium-Epitaxieschicht (401) gebildet wird und
in einem zweiten Schritt das p-dotierte Halbleitermaterial zwischen den n-dotierten sieb- bzw. netzartigen Schichten mittels eines Ätzmediums zur Bildung einer Deckelelektrode (1502) porös geätzt wird und
in einem dritten Schritt unterhalb der sieb- bzw. netzartigen n-dotierten Schicht der Deckelelektrode (1502) ein Hohlraum (201) gebildet wird.

2. Verfahren nach Anspruch 1, **dadurch gekennzeichnet, dass**
auf die poröse Deckelektrode (1502) eine Verschlussschicht aufgebracht wird, wobei der bei der Abscheidung herrschende Druck den Druck im Hohlraum definiert.

3. Verfahren nach Anspruch 1, **dadurch gekennzeichnet, dass** die p-dotierte Schicht mittels einer Epitaxieschicht auf dem Halbleitersubstrat vor dem ersten Schritt aufgebracht wird.

4. Verfahren nach Anspruch 1, **dadurch gekennzeichnet,**
**daß** der zweite Schritt einen ersten Unterschritt aufweist, während dem unter der ersten porösen Schicht (104) eine zweite poröse Schicht (105) mit einer Porosität von mehr als ca. 70 % und weniger als 100 %, vorzugsweise ca. 85 bis 95 %, gebildet wird.

5. Verfahren nach Anspruch 4, **dadurch gekennzeichnet,**
**daß** der Hohlraum bzw. die Kaverne (201) durch einen Temperschritt aus der zweiten porösen Schicht gebildet wird.

6. Verfahren nach Anspruch 1, **dadurch gekennzeichnet,**
**daß** in einem ersten Unterschritt des zweiten Schritts eine Zugangsöffnung bzw. ein einseitig offener Hohlraum (1101; 1201; 1401) in Richtung auf die erste poröse Schicht (1001; 1301) und/oder auf eine zweite poröse Schicht gebildet wird, wobei die erste und/oder zweite poröse Schicht ganz oder teilweise bevorzugt über die Zugangsöffnung bzw. den einseitig offenen Hohlraum entfernt wird.

7. Verfahren nach Anspruch 1, **dadurch gekennzeichnet,**
**daß** der zweite Schritt einen ersten Unterschritt aufweist, während dem unter der ersten porösen Schicht (104) ein zunächst flächenhafter Hohlraum gebildet wird, und sich der zunächst flächenhafte Hohlraum in die Tiefe ausdehnt und so aus dem zunächst flächenhaften Hohlraum der Hohlraum bzw. die Kaverne (201) entsteht.

8. Verfahren nach einem der Ansprüche 1 bis 7, **dadurch gekennzeichnet,**
**daß** die erste und/oder zweite poröse Schicht (104, 105) durch ein oder mehrere Ätzmedien gebildet wird bzw. gebildet werden, wobei das Ätzmedium und/oder die Ätzmedien vorzugsweise Flußsäure, HF-Säure, aufweisen oder aus Flußsäure bestehen.

9. Verfahren nach Anspruch 8, **dadurch gekennzeichnet,**
**daß** das Ätzmedium bzw. die Ätzmedien mit einem oder mehreren Zusätzen versehen ist bzw. sind, wie Zusätzen zur Verringerung der Blasenbildung, zur Verbesserung der Benetzung und/oder zur Verbesserung der Trocknung, wie insbesondere ein Alkohol, wie beispielsweise Äthanol, wobei die Volumenkonzentration des Zusatzes, wie insbesondere Äthanol, bei Äthanol vorzugsweise ca. 60 % bis ca. 100 % , beträgt.

10. Verfahren nach einem der Ansprüche 1 bis 9, **dadurch gekennzeichnet,**
**daß** die erste und/oder zweite poröse Schicht (104, 105) unter Anlegen eines elektrischen Feldes zwischen der Oberseite und der Unterseite des Halbleiterbauelements (100; ...; 2200) und der Einstellung eines elektrischen Stroms gebildet wird.

11. Verfahren nach einem der Ansprüche 1 bis 10, **dadurch gekennzeichnet,**
**daß** die Verfahrensparameter zur Bildung der zweiten porösen Schicht (105) bzw. zur Bildung des zunächst flächenhaften Hohlraums derart gewählt werden, daß die Ausdehnungsgeschwindigkeit der Poren bzw. Hohlräume in der zweiten porösen Schicht deutlich höher ist als die Ausdehnungsgeschwindigkeit der Poren bzw. Hohlräume zur Bildung der ersten porösen Schicht (104).

12. Verfahren nach einem der Ansprüche 7 bis 11, **dadurch gekennzeichnet,**
**daß** die Verfahrensparameter zur Bildung des zunächst flächenhaften Hohlraums derart gewählt werden, daß die Poren bzw. Hohlräume der zweiten porösen Schicht (105) einander in lateraler Richtung "überlappen" und so eine einzige zunächst flächenhafte Pore bzw. ein einziger zunächst flächenhafter Hohlraum gebildet wird.

13. Verfahren nach einem der Ansprüche 8 bis 12, **dadurch gekennzeichnet,**
**daß** die Dotierung des zu ätzenden Halbleitersubstrats (101), wie insbesondere ein Siliziumsubstrat, die Stromdichte in dem Ätzmedium bzw. in den Ätzmedien, die Flußsäure-Konzentration in dem Ätzmedium bzw. in den Ätzmedien, ein oder mehrere Zusätze zum Ätzmedium bzw. zu den Ätzmedien und die Temperatur Verfahrensparameter darstellen.

14. Verfahren nach einem der Ansprüche 1 bis 13, **dadurch gekennzeichnet,**
**daß** auf der ersten porösen Schicht (104) eine Epitaxieschicht (301; 401), wie beispielsweise eine Siliziumschicht, abgeschieden wird, die vorzugsweise monokristallin ist.

15. Kapazitiver Absolutdrucksensor (1500, 1600), insbesondere mit einem mehrschichtigen Halbleiterbauelement, welcher ein Siliziumsubstrat (101) mit wenigstens einer p-dotierten Silizium-Epitaxieschicht (401) aufweist, und einem Hohlraum bzw. einer Kaverne (201), insbesondere hergestellt nach einem der Ansprüche 1 bis 14 (siehe ursprünglichen A17),
**dadurch gekennzeichnet, daß**
der Absolutdrucksensor sowohl eine Bodenelektrode (1501) in Form einer sieb- bzw. netzartige n-dotierte Schicht im p-dotierten Siliziumsubstrat (101) als auch eine Deckelelektrode (1502) als sieb- bzw. netzartige n-dotierte Schicht oberhalb des Hohlraums bzw. der Kaverne (201) in der Silizium-Epitaxieschicht (401) aufweist.

16. Absolutdrucksensor (1600) nach Anspruch 15, **dadurch gekennzeichnet, dass** auf der Deckelelektrode (1601) eine Verschlußschicht aufgebracht ist, die den Hohlraum druckdicht abschließt.

## Claims

1. Method for producing a capacitive absolute pressure sensor (1500, 1600), in particular by means of a multilayered semiconductor component, wherein a p-doped silicon substrate (101) with at least one p-doped silicon epitaxial layer (401) is provided,
**characterized in that**
in a first step, for forming a bottom electrode (1501), a mesh- or net-like n-doped layer is formed in the p-doped silicon substrate (101), and for forming a top electrode (1502), a mesh- or net-like n-doped layer is formed in the p-doped silicon epitaxial layer (401) and
in a second step the p-doped semiconductor material between the n-doped mesh- or net-like layers is etched in a porous fashion by means of an etching medium for forming a top electrode (1502) and
in a third step a hollow space (201) is formed between the mesh- or net-like n-doped layer of the top electrode (1502).

2. Method according to Claim 1, **characterized in that** a closure layer is applied to the porous top electrode (1502) wherein the pressure prevailing during the deposition defines the pressure in the hollow space.

3. Method according to Claim 1, **characterized in that** the p-doped layer is applied by means of an epitaxial layer on the semiconductor substrate before the first step.

4. Method according to Claim 1, **characterized in that** the second step has a first substep, during which a second porous layer (105) having a porosity of more than approximately 70% and less than 100%, preferably approximately 85 to 95%, is formed below the first porous layer (104).

5. Method according to Claim 4, **characterized in that** the hollow space or the cavity (201) is formed from the second porous layer by a heat treatment step.

6. Method according to Claim 1, **characterized in that** in a first substep of the second step an access opening or a hollow space (1101; 1201; 1401) open on one side is formed in the direction of the first porous layer (1001, 1301) and/or a second porous layer, wherein the first and/or second porous layer is removed wholly or partly preferably via the access opening or the hollow space open on one side.

7. Method according to Claim 1, **characterized in that** the second step has a first substep, during which an initially planar hollow space is formed below the first porous layer (104), and the initially planar hollow space expands into the depth and the hollow space or the cavity (201) thus arises from the initially planar hollow space.

8. Method according to any of Claims 1 to 7, **characterized in that**
the first and/or second porous layer (104, 105) is formed or are formed by one or a plurality of etching media, wherein the etching medium and/or the etching media preferably comprise(s) hydrofluoric acid, HF acid, or consist(s) of hydrofluoric acid.

9. Method according to Claim 8, **characterized in that** the etching medium or the etching media is or are provided with one or a plurality of additives, such as additives for reducing blistering, for improving wetting and/or for improving drying, such as in particular an alcohol, such as ethanol, for example, wherein the volume concentration of the additive, such as in particular ethanol, is preferably approximately 60% to approximately 100% in the case of ethanol.

10. Method according to any of Claims 1 to 9, **characterized in that**
the first and/or second porous layer (104, 105) is formed with application of an electric field between the top side and the underside of the semiconductor component (100; ...; 2200) and the setting of an electric current.

11. Method according to any of Claims 1 to 10, **characterized in that**
the method parameters for forming the second porous layer (105) or for forming the initially planar hollow space are chosen in such a way that the expansion rate of the pores or hollow spaces in the second porous layer is significantly higher than the expansion rate of the pores or hollow spaces for forming the first porous layer (104).

12. Method according to any of Claims 7 to 11, **characterized in that**
the method parameters for forming the initially planar hollow space are chosen in such a way that the pores or hollow spaces of the second porous layer (105) "overlap" one another in a lateral direction and a single initially planar pore or a single initially planar hollow space is thus formed.

13. Method according to any of Claims 8 to 12, **characterized in that**
the doping of the semiconductor substrate (101) to be etched, such as in particular a silicon substrate, the current density in the etching medium or in the etching media, the hydrofluoric acid concentration in the etching medium or in the etching media, one or a plurality of additives to the etching medium or to the etching media and the temperature constitute method parameters.

14. Method according to any of Claims 1 to 13, **characterized in that**
an epitaxial layer (301; 401), such as a silicon layer, for example, which is preferably monocrystalline, is deposited on the first porous layer (104).

15. Capacitive absolute pressure sensor (1500, 1600), in particular having a multilayered semiconductor component, said sensor comprising a silicon substrate (101) with at least one p-doped silicon epitaxial layer (401), and having a hollow space or a cavity (201), in particular produced according to any of Claims 1 to 14 (see original Claim 17),
**characterized in that**
the absolute pressure sensor comprises both a bottom electrode (1501) in the form of a mesh- or net-like n-doped layer in the p-doped silicon substrate (101) and a top electrode (1502) as a mesh- or net-like n-doped layer above the hollow space or the cavity (201) in the silicon epitaxial layer (401).

16. Absolute pressure sensor (1600) according to Claim 15, **characterized in that** a closure layer is applied on the top electrode (1601) and seals the hollow space in a pressure-tight manner.

## Revendications

1. Procédé de fabrication d'un capteur capacitif de pression absolue (1500, 1600), en particulier à l'aide d'un composant semi-conducteur multicouche, dans lequel est prévu un substrat de silicium dopé p (101), comportant au moins une couche épitaxiale de silicium dopée p (401),
**caractérisé en ce que**, dans une première étape, pour former une électrode de fond (1501), on forme une couche dopée n de type tamis ou réseau dans le substrat de silicium dopé p (101), et, pour former une électrode de recouvrement (1502), une couche dopée n de type tamis ou réseau dans la couche épitaxiale de silicium dopée p (401), et
dans une deuxième étape, on soumet à une gravure poreuse le matériau semi-conducteur dopé p entre les couches de type tamis ou réseau dopées n, à l'aide d'un agent de gravure pour former une électrode de recouvrement (1502) et
dans une troisième étape, on forme une cavité (201) en-dessous de la couche dopée n, de type tamis ou réseau, de l'électrode de recouvrement (1502).

2. Procédé selon la revendication 1, **caractérisé en ce qu'**on applique sur l'électrode de recouvrement poreuse (1502) une couche de fermeture, la pression qui règne lors du dépôt définissant la pression dans la cavité.

3. Procédé selon la revendication 1, **caractérisé en ce que** la couche dopée p est appliquée avant la première couche sur le substrat semi-conducteur à l'aide d'une couche épitaxiale.

4. Procédé selon la revendication 1, **caractérisé en ce que** la deuxième étape comprend une première sous-étape, au cours de laquelle une deuxième couche poreuse (105), ayant une porosité supérieure à environ 70 % et inférieure à 100 %, de préférence d'environ 85 à 95 %, est formée en-dessous de la première couche poreuse (104).

5. Procédé selon la revendication 4, **caractérisé en ce que** la cavité ou la caverne (201) est formée par une étape de mise en température à partir de la deuxième couche poreuse.

6. Procédé selon la revendication 1, **caractérisé en ce que**, dans une première sous-étape de la deuxième étape, on forme une ouverture d'accès ou une cavité ouverte sur un côté (1101 ; 1201 ; 1401) dans la direction allant vers la première couche poreuse (1001 ; 1301) et/ou vers une deuxième couche poreuse, la première et/ou la deuxième couche poreuse étant en totalité ou en partie éloignées, de préférence sur l'ouverture d'accès ou la cavité ouverte sur un côté.

7. Procédé selon la revendication 1, **caractérisé en ce que** la deuxième étape comprend une première sous-étape, au cours de laquelle on forme en-dessous de la première couche poreuse (104) une cavité d'abord plate, et on étend en profondeur la cavité d'abord plate, en créant ainsi, à partir de la cavité d'abord plate, la cavité ou la caverne (201).

8. Procédé selon l'une des revendications 1 à 7, **caractérisé en ce que** la première et/ou la deuxième couche poreuse (104, 105) est formée/sont formées par un ou plusieurs agents de gravure, l'agent de gravure et/ou les agents de gravure comprenant de préférence de l'acide fluorhydrique, de l'acide HF, ou étant constitués d'acide fluorhydrique.

9. Procédé selon la revendication 8, **caractérisé en ce que** l'agent de gravure ou les agents de gravure est pourvu/sont pourvus d'un ou plusieurs additifs, tels que des additifs pour diminuer la formation de bulles, pour améliorer le mouillage et/ou pour améliorer le séchage, tels en particulier qu'un alcool, tel par exemple que l'éthanol, la concentration volumique de l'additif, tel qu'en particulier l'éthanol, étant dans le cas de l'éthanol de préférence d'environ 60 % à environ 100 %.

10. Procédé selon l'une des revendications 1 à 9, **caractérisé en ce que** la première et/ou la deuxième couche poreuse (104, 105) sont formées par application d'un champ électrique entre la face supérieure et la face inférieure du composant semi-conducteur (100 ; ... ; 2200), et avec ajustement d'un courant électrique.

11. Procédé selon l'une des revendications 1 à 10, **caractérisé en ce que** les paramètres du procédé pour la formation de la deuxième couche poreuse (105) ou pour la formation de la cavité d'abord plate sont choisis de telle sorte que la vitesse de dilatation des pores ou des cavités dans la deuxième couche poreuse soit nettement plus élevée que la vitesse de dilatation des pores ou des cavités pour la formation de la première couche poreuse (104).

12. Procédé selon l'une des revendications 7 à 11, **caractérisé en ce que** les paramètres du procédé pour la formation de la cavité d'abord plate sont choisis de telle sorte que les pores ou cavités de la deuxième couche poreuse (105) se "chevauchent" les uns les autres dans la direction latérale, en formant ainsi un pore d'abord plat, unique, ou une cavité d'abord plate, unique.

13. Procédé selon l'une des revendications 8 à 12, **caractérisé en ce que** le dopage du substrat semi-conducteur à graver (101), tel en particulier qu'un substrat de silicium, la densité de courant dans l'agent de gravure ou dans les agents de gravure, la concentration de l'acide fluorhydrique dans l'agent de gravure ou dans les agents de gravure, un ou plusieurs additifs à l'agent de gravure ou aux agents de gravure, et la température, représentent des paramètres du procédé.

14. Procédé selon l'une des revendications 1 à 13, **caractérisé en ce qu'**on dépose sur la première couche poreuse (104) une couche épitaxiale (301 ; 401), telle par exemple qu'une couche de silicium, qui de préférence est monocristalline.

15. Capteur capacitif de pression absolue (1500, 1600), comprenant en particulier un composant semi-conducteur multicouche, qui comprend un substrat de silicium (101) comportant au moins une couche épitaxiale de silicium dopée p (401), et une cavité ou une caverne (201), en particulier fabriqué conformément à l'une des revendications 1 à 14 (voir A17 original),
**caractérisé en ce que** le capteur de pression absolue comprend tant une électrode de fond (1501) sous forme d'une couche dopée n de type tamis ou réseau dans le substrat de silicium dopé p (101), qu'une électrode de recouvrement (1502) sous forme d'une couche dopée n de type tamis ou réseau au-dessus de la cavité ou de la caverne (201) dans la couche épitaxiale de silicium (401).

16. Capteur de pression absolue (1600) selon la revendication 15, **caractérisé en ce qu'**au-dessus de l'électrode de recouvrement (1601) est appliquée une couche de fermeture, qui obture la cavité d'une manière étanche à la pression.
